# EUROPEAN PATENT APPLICATION

(11) **EP 4 730 712 A1**
(43) Date of publication of application: **22.04.2026**
(21) Application number: 24207840.0
(22) Date of filing: 21.10.2024
(51) Int. Cl.: H04L 12/10, H04L 12/40

(54) **COMMUNICATION SYSTEM, DEVICES OF THE COMMUNICATION SYTEM AND METHOD FOR THE DEVICE**

(71) Applicant: NXP B.V., 5656 AG Eindhoven (NL)
(72) Inventor: Müller, Steffen, 5656 AG Eindhoven (NL); Dubois, Antoine Fabien, 5656 AG Eindhoven (NL); Stoelben, Hardy, 5656 AG Eindhoven (NL); Kock, Jörg, 5656 AG Eindhoven (NL)
(74) Representative: Schmütz, Christian Klaus Johannes

(57) **Abstract**

The present disclosure relates to a coordinator device for a communication system, the coordinator device comprising: a power output interface for coupling to a power supply line, a communication interface for coupling to a communication line, a communication unit, a power supply interface, a first fuse unit, and a second fuse unit, wherein the first fuse unit is coupled between the power supply interface and the power output interface to provide electrical power at the power output interface; wherein the communication unit is coupled to the communication interface to transmit or receive communication signals; and wherein the second fuse unit is coupled between the power supply interface and the communication interface to provide electrical energy at the communication interface. The present disclosure also relates to a communication system, a peripheral device for the communication system and a method for the coordinator device.

## Description

### TECHNICAL FIELD

The present disclosure relates to a communication system, a coordinator device for the communication system, further devices of the for the communication system, and a method for the coordinator device.

### BACKGROUND

Modern automobiles include various electronic devices that implement, for example, engine control, power train control, airbag systems, antilock brake systems, cruise control, electric power steering, audio systems, window control systems, door control systems, mirror adjustment systems, and battery and recharging systems for hybrid/electric cars. The devices may be able to communicate with each other in an automobile via in-vehicle network (IVN) technologies, such as Ethernet.

A Controller Area Network (CAN) can be used for communications within vehicles, in particular within automobiles. Several CAN nodes may be connected to a joint CAN bus, such that the CAN nodes can communicate among each other over the CAN bus using a CAN protocol. The CAN protocol is used to enable communications between the various CAN nodes. The data link layer of the CAN protocol is standardized as International Standards Organization (ISO) 11898-1:2003. CAN Flexible Data-Rate or "CAN FD" and CAN XL are extensions of the standardized CAN data link layer protocol and is integrated into the ISO 11898-1:2015 standard.

Ethernet is a well-known technology, and the Institute of Electrical and Electronic Engineers (IEEE) 802.3 Working Group is a collection of standards that define physical layer and data link layer media access control (MAC) for wired Ethernet.

An emerging IEEE standard that may be particularly applicable to in-vehicle networks is IEEE 802.3cg, which is a protocol for 10 Mb/s single twisted-pair Ethernet, also referred to as 10BASE-T1S. 10BASE-TIS can enable multiple Ethernet nodes to connect to the same twisted-pair wire, also referred to as a "shared media". The IEEE 802.3cg physical layer (PHY) does not utilize CSMA/CD (Carrier Sense Multiple Access, Collision Detection) and introduces "PLCA" (physical layer collision avoidance) for media access control.

The electronic devices that communicate with each other may be arranged in a distributed manner. The distributed arrangement allows several devices to be supplied with electrical power separately. A separate fuse can be provided for each of the several devices. If one of the fuses triggers in the event of a fault, such as an electrical short circuit, then the device connected to the respective triggered fuse will no longer be supplied with electrical power. The other devices may continue to be supplied with electrical power due to the separate and dedicated fuses. A single fault therefore does not lead to the failure of a large number of devices.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a first aspect of the present disclosure, a coordinator device for a communication system is provided. The coordinator device comprising: a power output interface for coupling to a power supply line, a communication interface for coupling to a communication line, a communication unit, a power supply interface, a first fuse unit, and a second fuse unit, wherein the first fuse unit is coupled between the power supply interface and the power output interface to provide electrical power at the power output interface; wherein the communication unit is coupled to the communication interface to transmit or receive communication signals; and wherein the second fuse unit is coupled between the power supply interface and the communication interface to provide electrical energy at the communication interface.

In one or more embodiments, the first fuse unit is configured to detect a first fault of the power supply line via the power output interface, if the power supply line is coupled to the power output interface, and wherein the first fuse unit is configured to interrupt the coupling between the power output interface and the power supply interface in response to the detected first fault.

In one or more embodiments, the first fault is either a short circuit between at least two wires of the power supply line or an interruption of at least one wire of the power supply line.

In one or more embodiments, the second fuse unit is configured to detect a second fault of the communication line via the communication interface, if the communication line is coupled to the communication interface, and wherein the second fuse unit is configured to interrupt the coupling between the communication interface and the power supply interface in response to the detected second fault.

In one or more embodiments, the second fault is either a short circuit between at least two wires of the communication line or an interruption of at least one wire of the communication line.

In one or more embodiments, the coordinator device is configured to interrupt the coupling between the communication interface and the communication unit in response to the detected second fault.

In one or more embodiments, the communication device is configured to receive communication signals at the communication interface, in particular via the communication line from periphery devices, wherein the coordinator device comprising a control unit being configured to determine a number of active periphery devices based on the communication signals, and wherein the coordinator device is configured to adapt a first trigger threshold for detecting a short circuit between wires of the power supply line as a first fault depending on the number of active periphery devices.

In one or more embodiments, the coordinator device is configured to adapt a second trigger threshold for detecting a short circuit between wires of the communication line as a second fault depending on the number of active periphery devices.

In one or more embodiments, the coordinator device is configured to adapt the second trigger threshold in response to the detected first fault and depending on the number of active periphery devices.

In accordance with a second aspect of the present disclosure, a periphery device for a communication system is provided. The periphery device comprising: a power input interface for coupling to a power supply line, a communication interface for coupling to a communication line, a communication unit, and a power control unit, wherein the communication unit is coupled to the communication interface to send or receive communication signals, wherein the power control unit is coupled to the power input interface and the communication interface, wherein the power control unit comprising a power transfer terminal, and wherein the power control unit is configured to direct electrical power from the power input interface and/or the communication interface to the power transfer terminal.

In one or more embodiments, the power control unit is configured to detect a power demand at the power transfer terminal, wherein the periphery device is configured to detect its active status in response to an exceeding of the power demand above a predefined threshold power value, and wherein the periphery device is configured to send a status signal via the communication interface in response to the detection of the active status, wherein the status signal represents the active status of the periphery device.

In one or more embodiments, the power control unit is configured to detect an electrical power availability at the power input interface and/or at the communication interface, and wherein the power control unit is configured to direct electrical power to the power transfer terminal from at least the at least one interface wherein electrical power is available.

In accordance with a third aspect of the present disclosure, a communication system is provided. The communication system comprises: a coordinator device according to the first aspect of the present disclosure or according to any of the corresponding embodiments, several periphery devices according to the second aspect of the present disclosure or any of the corresponding embodiments, a power supply line, and a communication line, wherein the power supply line extends from the power output interface of the coordinator device to the power input interface of each periphery device, and wherein the communication line extends from the communication interface of the coordinator device to the communication interface of each periphery device.

In one or more embodiments, each periphery device is supplied with electrical power from the coordinator device either via the power supply line or via the communication line.

In accordance with a fourth aspect of the present disclosure, a method for a coordinator device for a communication system is provided, wherein the coordinator device comprising power output interface for coupling to a power supply line, a communication interface for coupling to a communication line, a communication unit, a power supply interface, a first fuse unit, and a second fuse unit, wherein the first fuse unit is coupled between the power supply interface and the power output interface, wherein the communication unit is coupled to the communication interface, wherein the second fuse unit is coupled between the power supply interface and the communication interface, and wherein the method comprising the following steps: (a) Providing electrical energy via the power output interface and/or via the communication interface; and (b) Sending or receiving communication signals via the communication interface.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figures 1 and 2 show simplified block diagrams of embodiments of the coordinator device and the communication system.
Figure 3 shows a simplified block diagram of a fuse unit.
Figure 4 shows a simplified block diagram of a peripheral device.
Figure 5 shows a simplified block diagram of a filter unit.
Figure 6 shows a simplified diagram of a current curve and corresponding threshold values.
Figure 7 shows a simplified flow chart of the method.

### DESCRIPTION OF EMBODIMENTS

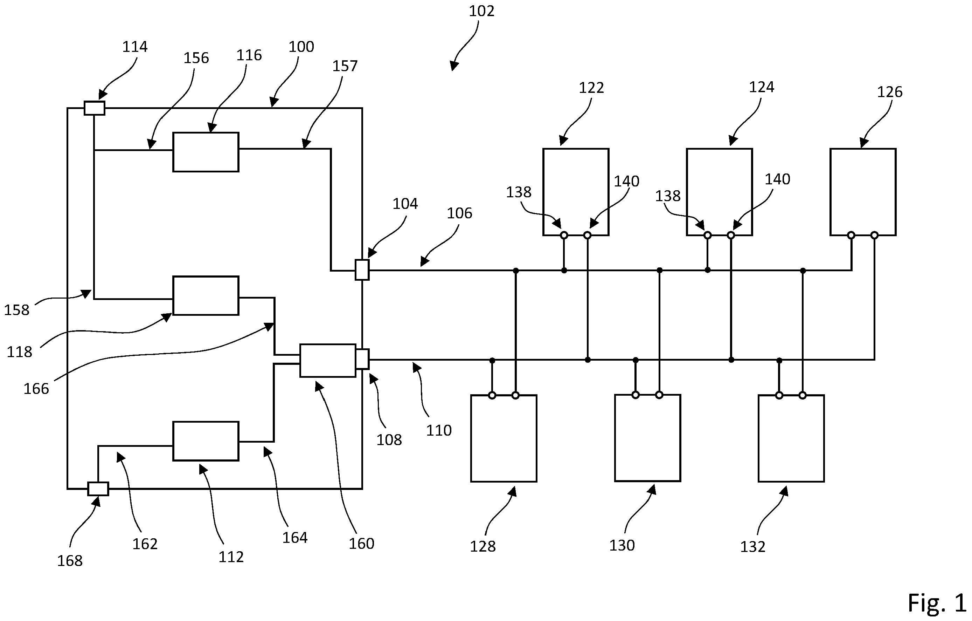

Figure 1 schematically shows an example of a communication system 102. The following explanations of the communication system 102 are explained particularly in connection with the 10Base-T1S standard, although in principle a different standard may be used.

The communication system 102 may comprise a device 100, referred to as the coordinator device 100, and a plurality of other devices 122-132, referred to as peripheral devices 122-132. The coordinator device 100 and the plurality of peripheral devices 122-132 may each be configured to communicate according to the 10Base-T1S standard. In another example, the communication system 102, the coordinator device 100 and/or each peripheral device 122-132 may be configured to communicate according to a standard other than the 10Base-T1S standard. The following explanations are therefore not to be understood as limited to the 10Base-T1S standard only.

The following explanations regarding the coordinator device 100 may, in an example, also refer to a single coordinator device 100 that is independent of the communication system 102. In another example, however, the following explanations regarding the coordinator device 100 may also relate to a configuration in which the coordinator device 100 forms part of the communication system 102. As an effect, the following explanations may relate to one or both configurations of the coordinator device 100.

The coordinator device 100 may be configured to perform communication with each of the peripheral devices 122-132. The coordinator device 100 may also be configured to provide electrical power to each of the peripheral devices 122-132.

The coordinator device 100 comprises a power output interface 104. The coordinator device 100 may be coupled to a power supply line 106 via the power output interface 104. The power supply line 106 may comprise a plurality of wires, in particular two wires. The power supply line 106 may extend from the power output interface 104 of the coordinator device 100 to each peripheral device 122-132. The power supply line 106 may be configured with branches, such that each respective branch of the power supply line 106 leads to a respective peripheral device 122-132. Each peripheral device 122-132 may comprise a power input interface 138. Each peripheral device 122-132 may be coupled to the power supply line 106 via the associated power input interface 138. As an effect, the power supply line 106 may extend from the power output interface 104 of the coordinator device 100 to each power input interface 138 of the plurality of peripheral devices 122-132, in particular in a branched manner.

The coordinator device 100 may comprise a power supply interface 114. The power supply interface 114 may be used to supply electrical power to the coordinator device 100. In addition, the coordinator device 100 includes a first fuse unit 116. The first fuse unit 116 is coupled between the power supply interface 114 and the power output interface 104. As an effect, electrical power may be transferred from the power input interface 114 to the power output interface 104 via the first fuse unit 116. The first fuse unit 116 may be understood in an example as an electrical fuse. A power line 156 may extend from the power supply interface 114 to the first fuse unit 116. A further power line 157 may extend from the first fuse unit 116 to the power output interface 104. The first fuse unit 116 may be configured, for example, to interrupt an electrical connection between the power supply interface 114 and the power output interface 104 in response to a fault. If the fault does not exist, the first fuse unit 116 may (re-)establish the electrical connection between the power supply interface 114 and the power output interface 104 to provide electrical power at the power output interface 104.

In an example, the power output interface 104 is for providing electrical power only and/or not for communication.

A plurality of peripheral devices 122-132 may be supplied with electrical power via the power output interface 104 of the coordinator device 100. In case a fault occurs in one of the peripheral devices 122-132 and/or a fault occurs in the electrical power supply line 106, the first fuse unit 116 may disconnect the electrical connection between the power supply interface 114 and the power output interface 104 in response to the fault. If the fault occurs in the electrical power supply line 106, there may be a need for the peripheral devices 122-132 to be supplied with electrical power via another path. If a fault occurs in one of the peripheral devices 122-132, there may be a need for the other, fault-free peripheral devices 122-132 to be supplied with electrical power via the other path. In order to keep the complexity as low as possible, it is desirable to use only a low number of fuse units 116, 118. As a result, there may be a need for an advantageous compromise in order to maintain the electrical supply to as many peripheral devices 122-132 as possible in the event of a fault, while at the same time avoiding a high level of complexity. An exemplary design that meets this compromise will be explained in the following paragraphs.

The coordinator device 100 comprises a communication interface 108. The communication interface 108 of the coordinator device 100 may be coupled to a communication line 110. The communication line 110 may comprise a plurality of wires, in particular two wires. In an example, the communication line 110 may comprise a twisted pair of wires or be formed by the twisted pair of wires. The communication interface 108 of the coordinator device 100 may be referred to as a first communication interface 108. Each peripheral device 122-132 may comprise a communication interface 140, each of which may be referred to as a second communication interface 140. The communication line 110 may extend from the first communication interface 108 of the coordinator device 100 to each second communication interface 140 of the peripheral devices 122-132. The communication line 110 may be configured in a branched manner such that each branch of the communication line 110 leads to each respective second communication interface 140 of the peripheral devices 122-132. As an effect, the communication line 110 may form a so-called multi-drop bus.

The coordinator device 100 further comprises a communication unit 112. The communication unit 112 may be coupled to the first communication interface 108 of the coordinator device 100 via a signal line 164. The communication unit 112 may be configured to generate a communication signal at the first communication interface 108 that represents digital data. The communication unit 112 may also be configured to receive a (different) communication signal via the first communication interface 108 that represents (different) digital data. The coordinator device 100 may comprise a further communication interface 168, which may also be referred to as a third communication interface 168. The third communication interface 168 of the coordinator device 100 may be a digital communication interface. The third communication interface 168 may be coupled to the communication unit 112 of the coordinator device 100 via a signal line 162. The communication unit 112 may be configured to receive or transmit data via the third communication interface 168. In an example, the communication unit 112 may receive digital data via the third communication interface 168 and generate a communication signal based on the received digital data at the first communication interface 108, such that the generated communication signal represents the received data. In another example, the communication unit 112 may be receiving a communication signal via the first communication interface 108, wherein the communication unit 112 is configured to transmit digital data via the third communication interface 168 that is represented by the received communication signal.

The first communication interface 108 of the coordinator device 100 serves a dual function. It was previously explained that the first communication interface 108 may be used to receive and/or transmit communication signals. Additionally, the first communication interface 108 may also be used to provide electrical power. The coordinator device 100 comprises a second fuse unit 118 coupled between the power supply interface 114 and the first communication interface 108 for providing electrical power to the first communication interface 108. A power line 158 may extend from the power supply interface 114 to the second fuse unit 118. From the second fuse unit 118, another power line 166 may extend to the first communication interface 108. As an effect, communication signals may be received or transmitted via the first communication interface 108 while electrical power may be provided via the first communication interface 108.

The communication line 110 may extend from the first communication interface 108 of the coordinator device 100 to each second communication interface 140 of the plurality of peripheral devices 122-132. Communication signals may be transmitted between the coordinator device 100 and the peripheral devices 122-132 via the communication line 110. Electrical power may be transmitted from the coordinator device 100 to one or more peripheral devices 122-132 via the communication line 110. As an effect, the peripheral devices 122-132 may be supplied with electrical energy via the power output interface 104 (and the power supply line 106) and/or via the communication interface 108 (and the communication line 110). If, in an example, a fault occurs in the power supply line 106, then the peripheral devices 122-132 may be supplied with electrical energy via the communication interface 108 instead of via the power output interface 104. As an effect, two paths may be provided in principle via the coordinator device 100 to supply a plurality of peripheral devices 122-132 with electrical energy. One path may supply electrical energy via the power output interface 104. The other path may supply electrical energy via the communication interface 108. As an effect, a redundant power supply may be provided. The coordinator device 100 also provides a way to minimize complexity. In an example, the coordinator device 100 comprises only two fuse units 116, 118, which minimizes the technical effort required to supply a plurality of peripheral devices 122-132. The number of peripheral devices 122-132 may be at least four, at least six, at least eight or at least ten, for example. The number of fuse units 116, 118 is thus significantly smaller than the number of peripheral devices 122-132 that can be supplied with electrical energy by the coordinator device 100 via redundant paths. In particular, the coordinator device 100 allows to overcome the prior art disadvantage of providing a dedicated fuse unit for each peripheral device 122-132. As an effect, a plurality of peripheral devices 122-132 can supplied with electrical power from the coordinator device 100 with relatively little technical effort, while being robust against faults, in particular at the power supply line 106 or at the communication line 110.

In an example, a unit 160, which may also be referred to as an overlay unit 160, may be a part of the communication interface 108 or may be combined with the communication interface 108. It was explained earlier that electrical power may be provided at the communication interface 108. The electrical power may be transferred by a power signal. The power signal may be generated if at least one peripheral device 122-132 draws electrical power via the communication interface 108. The overlay unit 160 may be configured, in an example, to transfer the power signal to the communication interface 108 and to superimpose a communication signal generated by the communication unit 112 on the power signal in order to transmit the communication signal via the communication interface 108, while providing electrical power via the power signal. As an effect, the coordinator device 100 may transmit the communication signals from the communication interface 108 via the communication line 110 to the peripheral devices 122-132, while simultaneously supplying at least one peripheral device 122-132 with electrical power via the communication interface 108 and the communication line 110. The overlay unit 160 may be configured, in an example, to transfer the power signal via the communication interface 108 and to forward a communication signal received via the communication interface 108 to the communication unit 112. As an effect, the coordinator device 100 may be receiving the communication signals via the communication interface 108, forwarding them to the communication unit 112 and simultaneously supplying at least one peripheral device 122-132 with electrical energy via the communication interface 108 and the communication line 110.

In an example, the first fuse unit 116 is configured to detect a first fault of the power supply line 106 via the power output interface 104 if the power supply line 106 is coupled to the power output interface 104. The first fault may be, for example, a short circuit between at least two wires of the power supply line 106 or an interruption of at least one wire of the power supply line 106. The first fuse unit 116 is coupled to the power output interface 104. If the power supply line 106 is also coupled to the power output interface 104, the first fuse unit 116 may be configured, in an example, to detect an electrical resistance between two wires of the power supply line 106. Furthermore, the first fuse unit 116 may be configured to detect the short circuit between the two wires of the power supply line 106 in response to a detected electrical resistance between the two wires of the power supply line 106 being less than a predefined first reference resistance. If the detected resistance (between the wires of the power supply line 106) is greater than the first reference resistance, it may be assumed that there is no short circuit between the two wires of the power supply line 106. If the detected resistance (between the wires of the power supply line 106) is less than the first reference resistance, it may be assumed that there is a short circuit between the two wires (of the power supply line 106). In an example, the first fuse unit may be configured to detect the interruption of at least one wire of the power supply line 106 in response to a detected electrical resistance between the interrupted wire and another wire of the power supply line being greater than a predefined second reference resistance. If the detected resistance is greater than the second reference resistance, then it may be assumed that there is an interruption (in particular an open circuit) in one of the two wires of the power supply line 106. If the detected resistance is less than the second reference resistance, then it may be assumed that neither of the two wires comprises an interruption. In a further example, the first fuse unit may be configured to detect the first fault of the power supply line 106 via the power output interface 104 in response to the detected electrical resistance between two wires of the power supply line 106 being either less than the first reference resistance or greater than the second reference resistance.

In an example, the first fuse unit 116 may be configured to provide the coupling between the power supply interface 114 and the power output interface 104, in particular via the power lines 156, 157, if and as long as the first fuse unit 116 has not detected a first fault. As an effect, the electrical connection between the power supply interface 114 and the power output interface 104 may be present if no first fault has been detected. The first fuse unit 116 may be configured to interrupt the coupling between the power supply interface 114 and the power output interface 104 in response to the detected first fault. If, in an example, the first fuse unit 116 detects a short circuit between two wires of the power supply line 106 as the first fault, then the first fuse unit 116 will interrupt the electrical coupling between the power supply interface 114 and the power output interface 104 in response to the detected first fault. The interruption of the electrical coupling may be used to prevent further failures from occurring. The interruption of the electrical coupling may also cause the peripheral devices 122-132 to no longer be supplied with electrical energy via the power output interface 104. However, instead of supplying power via the power output interface 104, the coordinator device 100 may supply electrical power to the peripheral devices 122-132 via the communication interface 108. In many cases, the alternative of supplying power via the communication interface 108 may prevent an operational interruption of the peripheral devices 122-132.

In an example, the second fuse unit 118 is configured to detect a second fault in the communication line 110 via the communication interface 108 if the communication line 110 is coupled to the communication interface 108. The second fault may be, for example, a short circuit between at least two wires of the communication line 110 or an interruption of at least one wire of the communication line 110. The second fuse unit 118 is coupled to the communication interface 108, in particular via the overlay unit 160. If the communication line 110 is also coupled to the communication interface 108, the second fuse unit 116 may be configured, in an example, to detect an electrical resistance between two wires of the communication line 110. Furthermore, the second fuse unit 118 may be configured to detect the short circuit between the two wires of the communication line 110 in response to a detected electrical resistance between the two wires of the communication line 110 being less than a predefined third reference resistance. If the detected resistance (between the two wires of the communication line 110) is greater than the third reference resistance, then it may be assumed that there is no short circuit between the two wires of the communication line 110. If the detected resistance (between the two wires of the communication line 110) is less than the third reference resistance, then it may be assumed that there is a short circuit between the two wires of the communication line. In an example, the second fuse unit 118 may be configured to detect the interruption of at least one wire of the communication line 110 in response to if the detected electrical resistance between the interrupted wire (of the communication line 110) and a further wire of the communication line 110 is greater than a predefined fourth reference resistance. If the detected resistance (between the wires of the communication line) is greater than the fourth reference resistance, then it may be assumed that there is an interruption in one of the two wires of the communication line 110. If the detected resistance (between two wires of the communication line 110) is less than the fourth reference resistance, then it can be assumed that neither of the two wires (of the communication line 110) comprises an interruption. In an example, the second fuse unit 118 may be configured to detect the second fault of the communication line 110 via the communication interface 108 in response to the detected electrical resistance between two wires of the communication line 110 being either less than the third reference resistance or greater than the fourth reference resistance.

In an example, the second fuse unit 118 may be configured to provide the coupling between the power supply interface 114 and the communication interface 108, in particular via the power lines 158, 166, if and as long as the second fuse unit 118 has not detected a second fault. As an effect, the electrical coupling between the power supply interface 114 and the communication interface 108 may be present if no second fault has been detected. The second fuse unit 118 may be configured to interrupt the coupling between the power supply interface 114 and the communication interface 108 in response to the detected second fault. If, in an example, the second fuse unit 118 detects a short circuit between two wires of the communication line 110 as the second fault, then the second fuse unit 118 will, in response to the detected second fault, interrupt the electrical coupling between the power supply interface 114 and the communication interface 108. By interrupting the electrical coupling, further faults may be prevented. The interruption of the electrical coupling may also cause the peripheral devices 122-132 to no longer to be supplied with electrical energy via the communication interface 108. The peripheral devices 122-132 may instead be supplied with electrical energy via the power output interface 104 and the power supply line 106.

The coordinator device 100 may be configured to interrupt the coupling between the communication unit 112 and the communication interface 108 in response to the detected second fault. In an example, the communication unit 112 may be configured and/or utilized to interrupt said coupling. The coordinator device 100 may be configured, in an example, to control the communication unit 112 in response to the detected second fault such that the communication unit 112 disconnects from the communication interface 108. The resulting interruption of communication with the peripheral devices 122-132 may be detected by the peripheral devices 122-132. In response to the interruption of communication, each peripheral device 122-132 may be configured in an example to change to a predetermined mode that ensures, for example, a safe operating state.

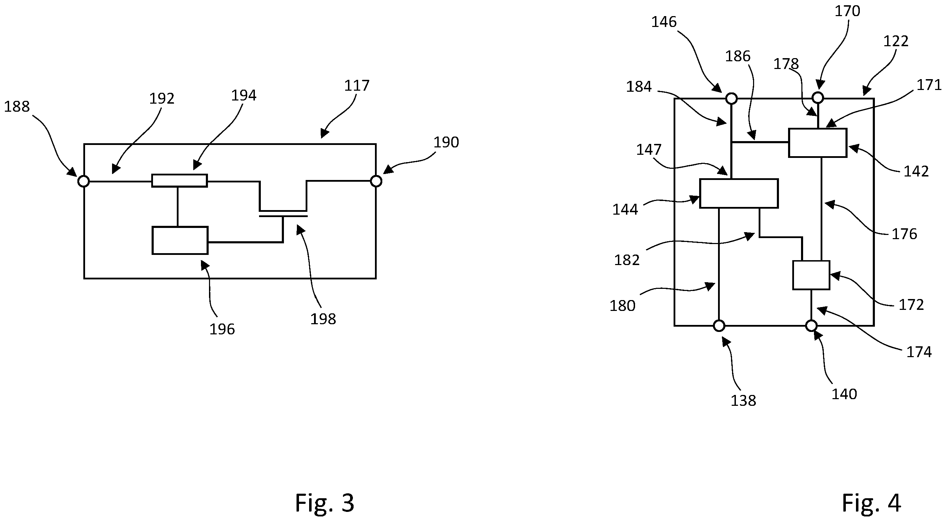

Figure 3 schematically shows an example of a fuse unit 117. The fuse unit 117 may be an example of the first fuse unit 116 and/or an example of the second fuse unit 118. The following explanations, features, technical effects and/or advantages of the fuse unit 117 may apply analogously to the first fuse unit 116 and/or the second fuse unit 118.

The fuse unit 117 may comprise an input terminal 188 and an output terminal 190. A power line 192 may extend from the input terminal 188 to the output terminal 190. The power line 192 may have integrated a transistor 198, also referred to as a decoupling transistor 198. The decoupling transistor 198 may be configured as a MOSFET transistor. A current detector 194 may be coupled to and/or integrated in the power line 192. The fuse unit 117 may further comprise a control unit 196, also referred to as a fuse control unit 196. The current detector 194 may be configured to detect a current flowing through the power line 192 and to generate a measurement signal that represents the detected current. The measurement signal may be an electrical voltage. The measurement signal may be transmitted from the current detector 194 to the fuse control unit 196 via a signal line. The fuse control unit 196 may be coupled to the decoupling transistor 198, in particular to a gate terminal of the decoupling transistor 198. In an example, the fuse control unit 196 may be configured, based on the detected current and/or the measurement signal, to interrupt the electrical connection between the input terminal 188 and the output terminal 190 if the detected current and/or the current represented by the measurement signal exceeds a predefined threshold value. The fuse control unit 196 may be controlled by a further control unit 120 of the coordinator device 100, in particular so that the control unit 120 can adapt the said threshold value.

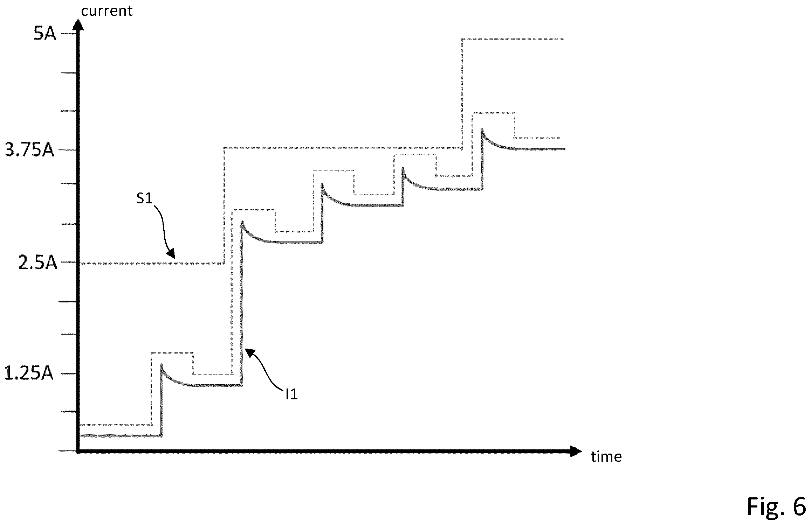

Figure 6 schematically shows an example of an electric current I1 over time flowing through the fuse unit 117. The threshold S1 may be adapted, in particular according to the number of active peripheral devices 122-132.

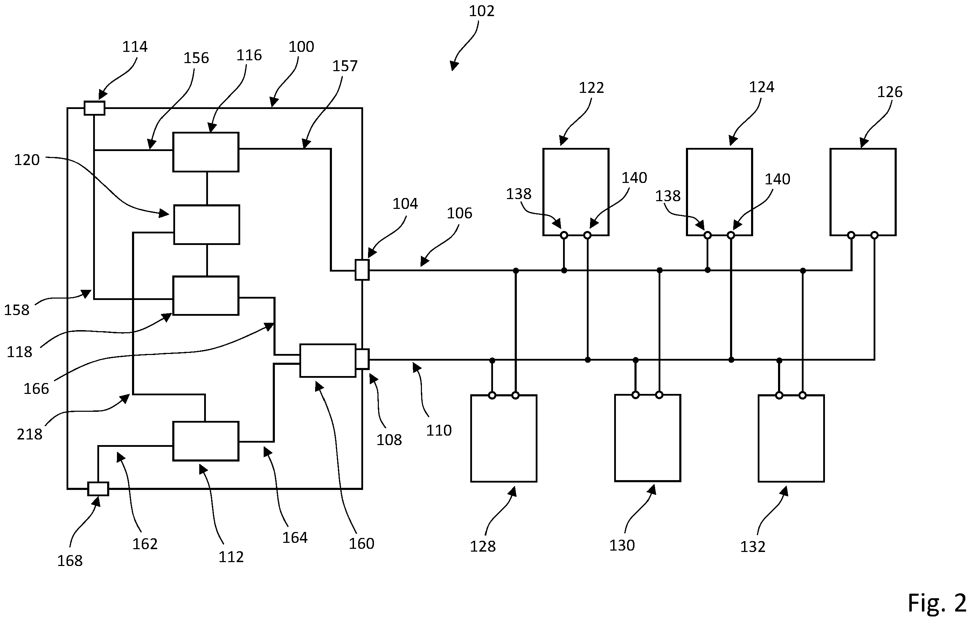

Figure 2 schematically shows an example of a further embodiment of the coordinator device 100 and/or an example of a further embodiment of the communication system 102. For the coordinator device 100 and/or for the communication system 102, reference is made to the previous explanations, advantageous features, technical effects and advantages in an analogous manner as previously explained in connection with Figure 1, 3 and/or 6.

The communication unit 112 is coupled to the communication interface 108, in particular via the signal lines 164 and/or the overlay unit 160. In an example, the communication unit 112 is configured to receive communication signals via the communication interface 108. In an example, the communication unit 112 may receive communication signals from a plurality of peripheral devices 122-132 via the communication interface 108. If the communication unit 112 receives a communication signal from one of the peripheral devices 122-132 via the communication interface 108, then it may be assumed that the peripheral device 122-132 that sent the communication signal is in an active state. If a peripheral device 122-132 is in the active state, the peripheral device 122-132 may also be referred to as an active peripheral device 122-132.

In an example, the coordinator device 100 may comprise a control unit 120. In an example, the control unit 120 may be coupled to the communication unit 112 via a signal line 218. The communication unit 112 may be configured to transmit a signal, also referred to as a status signal, to the control unit 120 via the signal line 218. If the communication unit 112 receives a communication signal from a peripheral device 122-132 via the communication interface 108, then the communication unit 112 may be configured to transmit the status signal to the control unit 120, wherein the status signal represents the peripheral device 122-132 (that transmitted the communication signal) and/or an associated identification number.

In an example, the controller 120 of the coordinator device 100 may be configured to determine a number of active peripheral devices 122-132 based at least indirectly on received communication signals and/or based on the at least one status signal. In an example, only communication signals and/or status signals during a predetermined time window, for example that defines the past 10 minutes, 20 minutes or 30 minutes, may be taken into account for the determination of the number of active peripheral devices 122-132. As an effect, active peripheral devices 122-132 only are taken into account during said time window. It was previously explained that the status signal may represent the active peripheral device 122-132 and/or an associated identification number. In another example, the status signal may be and/or represent a copy of the communication signal. In this example, the control unit 120 may be configured to detect the active peripheral device 122-132 based on the status signal.

In an example, the plurality of peripheral devices 122-132 may be electrically powered via the power output interface 104 and, more particularly, the power supply line 106. Each peripheral device 122-132 may comprise a power input interface 138. Each power input interface 138 may cause a predefined electrical resistance between the wires of the power supply line 106. As an effect, the electrical resistance that may be detected at the power output interface 104 between the wires of the power supply line 106 may decrease with the number of peripheral devices 122-132. In an example, the first fuse unit 116 may be configured to detect the electrical resistance between two wires of the power supply line 106 via the power output interface 104. In order to quickly and reliably detect an electrical short circuit between two wires of the power supply line 106 via the first fuse unit 116, it is advantageous to adjust a first trigger threshold for detecting the short circuit between the wires of the power supply line 106 according to the number of active peripheral devices 122-132. In an example, the first trigger threshold may define the value of the first reference resistor.

In an example, the control unit 120 may be coupled to the first fuse unit 116. The control unit 120 may be configured to adapt the first trigger threshold for detecting a short circuit via the first fuse unit 116. In an example, the control unit 120 may be configured to adapt the first trigger threshold, in particular the value for the first reference resistor, for detecting a short circuit between two wires of the power supply line 106 as a first fault, depending on the number of active peripheral devices 122-132. In an example, the control unit 120 may adjust the first trigger threshold inversely proportional to the number of active peripheral devices 122-132. The greater the number of active peripheral devices 122-132, the smaller the first trigger threshold, in particular the value of the first reference resistor, may be adjusted by the control unit 120. As an effect, a fast, precise and reliable detection of the first fault may be achieved via the first fuse unit 116.

In an example, the plurality of the peripheral devices 122-132 may be coupled to the first communication interface 108 of the coordinator device 100 via the communication line 110. Each peripheral device 122-132 may comprise a second communication interface 140. Each second communication interface 140 may have a predefined electrical resistance between the wires of the communication line 110. As an effect, the electrical resistance that can be detected at the first communication interface 108 between the wires of the communication line 110 may decrease with the number of peripheral devices 122-132. In an example, the second fuse unit 118 may be configured to detect the electrical resistance between two wires of the communication line 110 via the communication interface 108. To quickly and reliably detect an electrical short circuit between two wires of the communication line 110 via the second fuse unit 118, it had been found to be advantageous if a second trigger threshold for detecting the short circuit between the wires of the communication line 110 is adjusted according to the number of active peripheral devices 122-132. In an example, the second trigger threshold may define the value of the third reference resistor.

In an example, the control unit 120 may be coupled to the second fuse unit 118. The control unit 120 may be configured to adapt the second trigger threshold for detecting a short circuit via the second fuse unit 118. In an example, the control unit 120 may be configured to adapt the second trigger threshold, in particular the value for the third reference resistor, for detecting a short circuit between two wires of the communication line 110 as a second fault, depending on the number of active peripheral devices 122-132. In an example, the control unit 120 may adjust the second trigger threshold inversely proportional to the number of active peripheral devices 122-132. The greater the number of active peripheral devices 122-132, the smaller the second trigger threshold value, in particular the value of the third reference resistor, may be adjusted by the control unit 120. As an effect, a fast, precise and reliable detection of the second fault may be achieved via the second fuse unit 118.

It was previously explained that the first fuse unit 116 may detect a first fault in the power supply line 106, wherein the first fuse unit 116 can cause an interruption of the coupling between the power supply interface 114 and the power output interface 104 in response to the detection of the first fault. If at least one peripheral device 122-132 was supplied with electrical energy via the power output interface 104 before the first fault occurred and/or before the first fault was detected, then this at least one peripheral device 122-132 is supplied with electrical energy via the first communication interface 108 (and in particular the signal line 110) after the interruption of the coupling between the power supply interface 114 and the power output interface 104. As an effect, a larger number of active peripheral devices 122-132 may be supplied with electrical energy via the communication interface 108 as a result of the detection of the first fault and/or the aforementioned interruption of the coupling. In this circumstance, it may be advantageous to adjust the second trigger threshold for detecting a short circuit between the wires of the communication line 110, in particular to reduce it, in order to improve robust detection of the second fault via the second fuse unit 118. In an example, the control unit 120 may be configured to adjust the second trigger threshold, in particular the value of the third reference resistor, in response to the detected first fault and according to the number of active peripheral devices 122-132.

Figures 1 and 2 also each schematically illustrate an example of a communication system 102. The communication system 102 comprises the coordinator device 100 and a plurality of peripheral devices 122-132. In an example, the communication system 102 comprises at least four, six, or ten peripheral devices 122-132.

The communication system 102 further comprises a power line 106. In an example, the power line 106 is the only power line 106 of the communication system 102. The power line 106 may comprise multiple wires. The power line 106 may have a branched topology. The power supply line 106 extends from the power output interface 104 of the coordinator device 100 to each power input interface 138 of the peripheral devices 122-132. A first branch of the power supply line 106 may extend to the power input interface 138 of the first peripheral device 122. A second branch of the power supply line 106 may extend to the power input interface 138 of the second peripheral device 124. In a similar manner, each branch of the power supply line 106 may extend to a respectively associated power input interface 138 of the respective peripheral device 122-132. Each wire of the power supply line 106 may extend from the power output interface 104 into each branch and/or to each power input interface 138 of the peripheral devices 122-132.

The communication system 102 also comprises a communication line 110. In an example, the communication line 110 is the only communication line 110 of the communication system 102. The communication line 110 may comprise a plurality of wires. The communication line 110 may have a branched topology. A branched topology of the communication line 110 may be analogous to a branched topology of the power supply line 106. The communication line 110 extends from the first communication interface 108 of the coordinator device 100 to every second communication interface 140 of the peripheral devices 122-132. A first branch of the communication line 110 may extend to the second communication interface 140 of the first peripheral device 122. A second branch of the communication line 110 may extend to the second communication interface 140 of the second peripheral device 124. In a similar manner, each branch of the communication line 110 may be extended to a respectively associated second communication interface 140 of the respective peripheral device 122-132. Each wire of the communication line 110 may extend from the first communication interface 108 of the coordinator device 100 into each branch and/or to each second communication interface 140 of the peripheral devices 122-132.

The coordinator device 100 of the communication system 102 and/or each peripheral device 122-132 of the communication system 102 may be configured such that each peripheral device 122-132 is supplied with electrical power either via the power supply line 106 or via the communication line 110 from the coordinator device 100. As an effect, a redundant power supply is provided which, if a fault occurs in the power supply line 106 or in the communication line 110, allows the other line 106, 110 to be used to continue to supply power to the peripheral devices 122-132. This continued power supply may be used to continue the operation of the peripheral devices 122-132 and/or to enable the peripheral devices 122-132 to change to a safe mode. The use of exactly two lines, namely the power supply line 106 and the communication line 110, makes it possible to keep the technical complexity in the coordinator device 100 low. In particular, a large number of separate fuse units may be prevented.

Figures 1 and 2 each schematically show several examples of peripheral devices 122-132. Figure 4 schematically illustrates a further example of a peripheral device 122. The example of peripheral device 122 from Figure 4 may be understood in an analogous manner as an example for each of the plurality of peripheral devices 122-132. It is therefore not repeated.

The peripheral device 122 comprises a power input interface 138 and a communication interface 140. The communication interface 140 of the peripheral device 122 may also be referred to as a second communication interface 140. The second communication interface 140 is for coupling to the communication line 110. The power input interface 138 is for coupling to the power supply line 106.

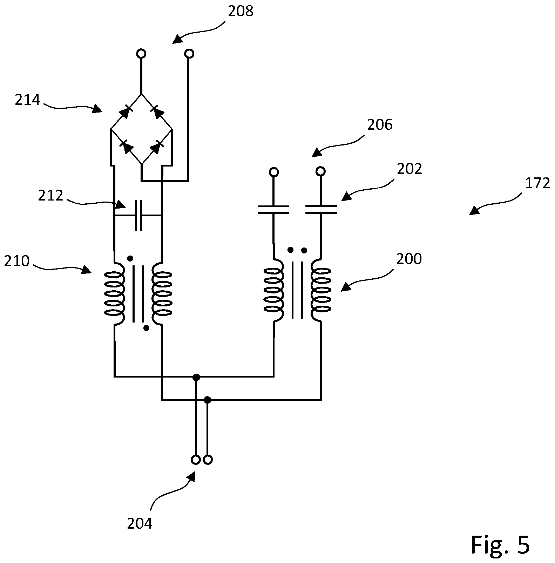

The peripheral device 122 may also comprise a communication unit 142, also referred to as a second communication unit 142. The second communication unit 142 is coupled to the second communication interface 140. In an example, the second communication unit 142 may be coupled to the second communication interface 140 via a signal line 176, a filter unit 172, and a further signal line 174. The signal line 176, the filter unit 172 and the signal line 174 may be connected in series in particular in the order mentioned to form the coupling between the second communication unit 142 and the second communication interface 140. An example of the filter circuit 172 is shown schematically in Figure 5. The example of the filter circuit 172 from Figure 5 will be discussed in more detail later.

The peripheral device 122 may also comprise a control unit 144, also referred to as a power control unit 144. The power control unit 144 may be coupled to both the power input interface 138 and the second communication interface 140. In an example, the power control unit 144 is coupled to the power input interface 138 via a power line 180 to receive electrical power via the power input interface 138. In an example, the power control unit 144 is coupled to the second communication interface 140 via the power line 182, the filter unit 172 and the signal line 174 in order to be able to receive electrical energy via the second communication interface 140. The power line 182, the filter unit 172 and the signal line 174 may be connected in series in the order mentioned to form the coupling between the power control unit 144 and the second communication interface 138.

A mixed signal consisting of a power signal and a superimposed communication signal may be received at the second communication interface 140. The overlay unit 160 of the coordinator device may be configured to generate the mixed signal at the first communication interface 108 of the coordinator device 100 if the overlay unit 160 receives the power signal via the second fuse unit 118 and/or the power signal 166 and simultaneously receives the communication signal via the first communication unit 112 and/or the signal line 164 of the coordinator device 100. If the overlay device 160 receives both of the aforementioned signals, i.e. the power signal and the communication signal, the overlay device may be configured to overlay the communication signal on the power signal, resulting in the mixed signal being generated and/or transmitted at the first communication interface 108. The mixed signal is transmitted via the communication line 110 to each second communication interface of each peripheral device 122-132.

The filter unit 172 of the peripheral device 122 may be configured to receive the mixed signal via the second communication interface 140. Furthermore, the filter unit 172 may be configured to transmit the communication signal, based on the mixed signal, to the second communication unit 142 (via the signal line 176) and to transmit the power signal, based on the mixed signal, to the power control unit 144 (via the power line 182). As an effect, the mixed signal may be split into the communication signal and the power signal via the filter unit 172.

The power control unit 144 may be configured to receive electrical energy via the power input interface 138 or via the second communication interface 140. To receive electrical energy via the power input interface 138, the power line 180 may also be taken into account. For receiving the electrical energy via the second communication interface 140, a series circuit comprising the signal line 174, the filter unit 172 and the power line 182 may also be taken into account. The power control unit 144 may be configured to select whether the electrical energy is received either via the power input interface 138, via the second communication interface 140, or via both, the power input interface 138 and the second communication interface 140.

The power control unit 144 may be comprise an output terminal 147, which may also be referred to as a power transfer terminal 147. The power transfer terminal 147 may be configured as a terminal or node provided within the peripheral device 122. The power control unit 144 may be configured to direct electrical energy from the power input interface 138 and/or from the second communication interface 140 to the power transfer terminal 147. The electrical energy directed to the power transfer terminal 147 may be utilized by a unit and/or device coupleable to the peripheral device 122 and/or the power transfer terminal 147. Thus, the further unit or device may be energized. The further unit or device may be, for example, an electric actuator, a sensor unit, or another electromechanical device.

In an example, the power control unit 144 is configured to detect electrical power availability at the power input interface 138 and/or at the second communication interface 140. The power control unit 144 may determine power availability via the power input interface 138 based, for example, on the presence or absence of a power signal at the power input interface 138. The power control unit 144 may determine power availability via the second communication interface 140 based, for example, on the presence or absence of a power signal component of the mixed signal (via the filter unit 172) at the second communication interface 140.

In an example, the power control unit 144 may be configured to direct electrical power from at least one interface 138, 140 of the two interfaces 138, 140 where electrical power is available to the power transfer terminal 147. As an effect, it may be ensured that an alternative and/or redundant power supply is provided at the power transfer terminal 147.

In an example, the peripheral device 122 comprises a power transfer interface 146. The power transfer interface 146 may be coupled to the power transfer terminal 147 of the power control unit 144 via the power line 184, so that electrical energy can be provided at the power transfer interface 146. A further device, for example an electric actuator, a sensor unit or another electromechanical device, may be coupled to the power transmission interface 146. The further device may be a part of the peripheral device 122.

The second communication unit 142 may be configured to receive a communication signal via the second communication interface 140, in particular via the signal line 174, the filter unit 172 and the signal line 176. The communication signal may represent data. The second communication unit 142 may be configured to transmit the data represented by the communication signal at a data output 171. In an example, the data output 171 may be coupled to a further communication interface 170 of the peripheral device 122 via the data signal line 178. The further communication interface 170 may also be referred to as a fourth communication interface 170. The second communication unit 142 may be configured to transmit the data represented by the communication signal via the fourth communication interface 170. In an example, the data may be transmitted to a device coupled to the fourth communication interface 170. Examples of a corresponding device have been mentioned previously.

In an example, if a device, such as a sensor unit, is coupled to the peripheral device 122 via the power output interface 146 and the fourth communication interface 170, the device, in particular the sensor unit, may have a certain power demand for supplying electrical power from the peripheral device 122. The device coupled to the peripheral device 122 may be supplied with electrical energy via the power transfer interface 146.

In an example, the power control unit 144 may be configured to detect a power demand for transferring electrical energy via the power transfer terminal 147 and/or the power transfer interface 146. The detected power demand may indicate an active state of the peripheral devices 122, since the peripheral device 122 passes the electrical energy from either the power input interface 138 or the second communication interface 140 to said device. The peripheral device 122, in particular the associated power control unit 144, may be configured to determine the active state of the peripheral device 122 in response to the detected power demand exceeding a predefined threshold. If the detected power demand is greater than the predefined threshold, then the peripheral device 122, in particular the power control unit 144, will determine the active state of the peripheral device 122. If the power demand is less than the predefined threshold, then the peripheral device 122, in particular the associated power control unit 144, will determine a deactivated state of the peripheral device 122. The peripheral device 122, in particular via the associated power control unit 144, is able to determine the active state and in particular also the deactivated state. The peripheral device 122 may signal the respective state, in particular the active state, to the coordinator device 100. The peripheral device 122 may be configured to send a status signal via the second communication interface 140 in response to determining the active state, wherein the status signal represents the active state of the peripheral device. In an example, the power control unit 144 may be coupled to the second communication unit 142 so that the power control unit 144 controls the second communication unit 142 to generate the status signal in response to the event if the power control unit 144 detected the active state of the peripheral device 122. The second communication unit 142 may generate a communication signal, in particular the status signal, at the second communication interface 140 via the filter unit 172. In an example, the status signal may be transmitted via the communication line 110 to the coordinator device 100, in particular to the associated first communication interface 108 of the coordinator device 100.

The foregoing explanations, features, technical effects and advantages explained in connection with the peripheral device 122 may be similarly applicable to each peripheral device 122-132.

In an example, the overlay unit 160 may be configured analogous to the filter unit 172 of the peripheral device 122. The overlay unit 160 may be configured in an example to forward a communication signal received via the first communication interface 108, in particular the status signal, to the first communication unit 112. The coordinator device 100 may receive a plurality of status signals via the first communication interface 108 and forward them to the first communication unit 112 via the overlay unit 160. Each status signal may represent a dedicated active peripheral device 122. This information may be transmitted from the first peripheral device via the signal line 218 to the control unit 120 of the coordinator device 100. The control unit 120 of the coordinator device 100 may be configured based on the number of active peripheral devices 122-132 to adapt the first and/or second fuse units 116, 118.

The first communication unit 112 of the coordinator device 100 and/or the second communication unit 142 of each peripheral device 122-132 may be designed for communication according to a CAN standard, such as Classic CAN, CAN FD or CAN XL, and/or according to an Ethernet standard, such as 10Base-T1s or 100-BaseT1, according to a LIN standard, or according to a FlexRay standard.

In an example where the first communication unit 112 of the coordinator device 100 is configured for communication in accordance with a CAN standard, the first communication unit 112 may comprise a CAN transceiver and in particular also a CAN controller. The first communication interface 108 of the coordinator device 100 may be coupled, for example, to a CAN bus interface of the CAN controller. A receive data interface and/or a transmit data interface of the CAN transceiver may be coupled to the CAN controller. A bidirectional data interface of the CAN controller may be coupled to the third communication interface 168 of the coordinator device 100.

In an example where the first communication unit 112 of the coordinator device 100 is configured to communicate in accordance with an Ethernet standard, the first communication unit 112 may be configured as an Ethernet node. The Ethernet node may comprise a MAC unit and a PHY unit. A bus interface of the PHY unit may be coupled to the first communication interface 108 of the coordinator device 100. A digital data interface may be coupled to the third communication interface 168 of the coordinator device 100.

An example of the filter unit 172 is schematically shown in Figure 5. The filter unit 172 may comprise an input terminal 204. The input terminal 204 may be coupled to the second communication interface 140 via the signal line 174. The filter unit 172 may comprise a first choke 200. The first choke 200 may be a common mode choke such that differential signals are passed by the common mode choke while common mode signals are blocked by the common mode choke. The first choke 200 may be coupled between the input terminal 204 and a first output terminal 206 of the filter unit 172. The first output terminal 206 may be coupled to the second communication unit 142 via the signal line 176. The filter unit 172 may also comprise capacitors 202 coupled between the first choke 200 and the output terminal 206, wherein the capacitors 202 may serve to low-pass filter the communication signal.

In an example, the filter unit 172 may comprise a further choke 210. The further choke 120 may also be referred to as a second choke 210. The second choke 210 may, in an example, be configured as a differential mode choke. The differential mode choke 210 may be configured to pass common mode signals, while differential mode signals are blocked by the differential mode choke. In addition, the filter unit 172 may comprise a rectifier 214. The differential mode choke 210 and the rectifier 214 may be coupled in series between the input terminal 204 and a further, second output terminal 208 of the filter unit 172. The second output terminal 208 of the filter unit 172 may be coupled to the power control unit 144.

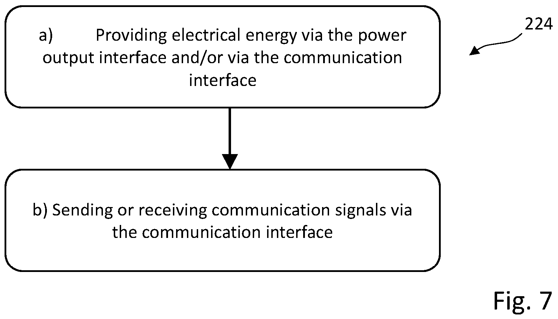

An example of a flow chart diagram of the method 224 is schematically shown in Figure 7. The method 224 may be carried out by the coordinator device 100. The method 224 may be comprised of the following steps:
a) Providing electrical energy via the power output interface and/or via the communication interface; and
b) Sending or receiving communication signals via the communication interface.

The preceding explanations, features, technical effects, and advantages as already explained for coordinator device 100 and/or communication system 102 may apply in an analogous manner to the method 224.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A coordinator device for a communication system, the coordinator device comprising:
a power output interface for coupling to a power supply line,
a communication interface for coupling to a communication line,
a communication unit,
a power supply interface,
a first fuse unit, and
a second fuse unit,
wherein the first fuse unit is coupled between the power supply interface and the power output interface to provide electrical power at the power output interface;
wherein the communication unit is coupled to the communication interface to transmit or receive communication signals; and
wherein the second fuse unit is coupled between the power supply interface and the communication interface to provide electrical energy at the communication interface.

2. The coordinator device according to the preceding claim, wherein the first fuse unit is configured to detect a first fault of the power supply line via the power output interface, if the power supply line is coupled to the power output interface, and wherein the first fuse unit is configured to interrupt the coupling between the power output interface and the power supply interface in response to the detected first fault.

3. The coordinator device according to the preceding claim, wherein the first fault is either a short circuit between at least two wires of the power supply line or an interruption of at least one wire of the power supply line.

4. The coordinator device according to any of the preceding claims, wherein the second fuse unit is configured to detect a second fault of the communication line via the communication interface, if the communication line is coupled to the communication interface, and wherein the second fuse unit is configured to interrupt the coupling between the communication interface and the power supply interface in response to the detected second fault.

5. The coordinator device according to the preceding claim, wherein the second fault is either a short circuit between at least two wires of the communication line or an interruption of at least one wire of the communication line.

6. The coordinator device according to the preceding claim, wherein the coordinator device is configured to interrupt the coupling between the communication interface and the communication unit in response to the detected second fault.

7. The coordinator device according to any of the preceding claims, wherein the communication device is configured to receive communication signals at the communication interface, in particular via the communication line from periphery devices, wherein the coordinator device comprising a control unit being configured to determine a number of active periphery devices based on the communication signals, and wherein the coordinator device is configured to adapt a first trigger threshold for detecting a short circuit between wires of the power supply line as a first fault depending on the number of active periphery devices.

8. The coordinator device according to the preceding claim, wherein the coordinator device is configured to adapt a second trigger threshold for detecting a short circuit between wires of the communication line as a second fault depending on the number of active periphery devices.

9. The coordinator device according to the preceding claim in combination with claim 2, wherein the coordinator device is configured to adapt the second trigger threshold in response to the detected first fault and depending on the number of active periphery devices.

10. A periphery device for a communication system, the periphery device comprising:
a power input interface for coupling to a power supply line,
a communication interface for coupling to a communication line,
a communication unit, and
a power control unit,
wherein the communication unit is coupled to the communication interface to send or receive communication signals,
wherein the power control unit is coupled to the power input interface and the communication interface,
wherein the power control unit comprising a power transfer terminal, and
wherein the power control unit is configured to direct electrical power from the power input interface and/or the communication interface to the power transfer terminal.

11. The periphery device according to the preceding claim, wherein the power control unit is configured to detect a power demand at the power transfer terminal, wherein the periphery device is configured to detect its active status in response to an exceeding of the power demand above a predefined threshold power value, and wherein the periphery device is configured to send a status signal via the communication interface in response to the detection of the active status, wherein the status signal represents the active status of the periphery device.

12. The periphery devices according to any of the preceding claims 10 to 11, wherein the power control unit is configured to detect an electrical power availability at the power input interface and/or at the communication interface, and wherein the power control unit is configured to direct electrical power to the power transfer terminal from at least the at least one interface wherein electrical power is available.

13. A Communication system, which comprises:
a coordinator device according to any of the preceding claims 1 to 9,
several periphery devices each according to any of the preceding claims 10 to 12,
a power supply line, and
a communication line,
wherein the power supply line extends from the power output interface of the coordinator device to the power input interface of each periphery device, and
wherein the communication line extends from the communication interface of the coordinator device to the communication interface of each periphery device.

14. The communication system according to the preceding claim, wherein each periphery device is supplied with electrical power from the coordinator device either via the power supply line or via the communication line.

15. A method for a coordinator device for a communication system, wherein the coordinator device comprising power output interface for coupling to a power supply line, a communication interface for coupling to a communication line, a communication unit, a power supply interface, a first fuse unit, and a second fuse unit, wherein the first fuse unit is coupled between the power supply interface and the power output interface, wherein the communication unit is coupled to the communication interface, wherein the second fuse unit is coupled between the power supply interface and the communication interface, and wherein the method comprising the following steps:
a) Providing electrical energy via the power output interface and/or via the communication interface; and
b) Sending or receiving communication signals via the communication interface.
